Europäisches Patentamt

European Patent Office

Office européen des brevets

(19)

(11) **EP 0 987 774 A2**

(12) **EUROPEAN PATENT APPLICATION**

(43) Date of publication:
**22.03.2000 Bulletin 2000/12**

(51) Int. Cl.$^7$: **H01L 51/20**

(21) Application number: **99104907.3**

(22) Date of filing: **12.03.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **16.09.1998 US 154216**

(71) Applicant:
**The Trustees of Princeton University Princeton, NJ 08544-0036 (US)**

(72) Inventors:
• **Forrest, Stephen R.**
  **Princeton, New Jersey 08540 (US)**
• **Gu,Gong**
  **Princeton, New Jersey 08540 (US)**

(74) Representative:
**KEIL & SCHAAFHAUSEN Patentanwälte, Cronstettenstrasse 66 60322 Frankfurt am Main (DE)**

(54) **An electrode having enhanced hole injection**

(57) The present invention provides a method of fabricating an organic light emitting device. A layer of indium tin oxide is deposited. While the layer of indium tin oxide is being deposited, a controlled amount of additional oxygen is incorporated into a surface of the layer of indium tin oxide. An organic layer is then deposited onto the surface.

EP 0 987 774 A2

## Description

### FIELD OF THE INVENTION

The present invention relates to organic light emitting devices (OLEDs), and more particularly to an improved electrode for use in such devices.

### BACKGROUND

Organic light emitting devices (OLEDs) are comprised of one or more organic layers in which one of the layers is comprised of an organic material that can be made to electroluminesce, by applying a voltage across the device. C.W. Tang et al., *Appl. Phys. Lett.* 51, 913 (1987). Certain OLEDs have been shown to have sufficient brightness, range of color and operating lifetimes for use as a practical alternative technology to LCD-based full color flat-panel displays. S.R. Forrest, P.E. Burrows and M.E. Thompson, Laser Focus World, Feb. 1995. Since many of the thin organic films used in such devices are transparent in the visible spectral region, they allow for the realization of a completely new type of display pixel in which red (R), green (G), and blue (B) emitting OLEDs are placed in a vertically stacked geometry to provide a simple fabrication process, a small R-G-B pixel size, and a large fill factor.

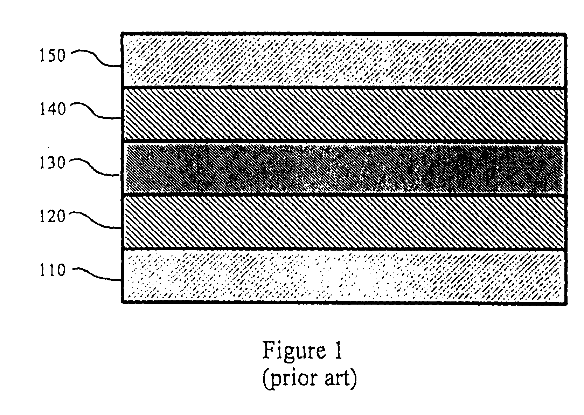

Figure 1 (prior art) shows a double heterostructure OLED 100. An anode 110, a hole transporting layer (HTL) 120, an emissive layer (EL) 130, an electron transporting layer (ETL) 140, and a cathode 150 are stacked in that order. When a voltage is applied between anode 110 and cathode 150, current flows from anode 110, across HTL 120, to EL 130, primarily by conduction of holes traveling from anode 110 to EL 130. Similarly, current flows from EL 130, across ETL 140, to cathode 150, primarily by conduction of electrons traveling from cathode 150 to EL 130. Holes are injected into EL 130 by HTL 120, and electrons are injected into EL 130 by ETL 140. The electrons and holes combine to form excitons in EL 130, which then decay preferentially by a photoemissive mechanism to emit light.

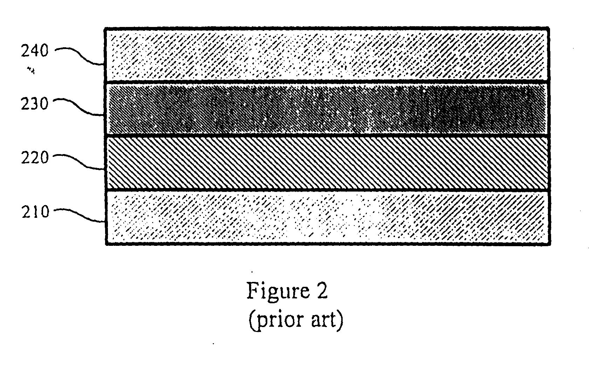

Figure 2 (prior art) shows a single heterostructure OLED 200. An anode 210, a hole transporting layer (HTL) 220, an emissive layer (EL) 230, and a cathode 240 are stacked in that order. A single heterostructure OLED functions in a manner similar to a double heterostructure OLED, except that the EL also functions as a transport layer. For example, in the OLED of Figure 2, EL 230 also functions as an ETL. When a voltage is applied between anode 210 and cathode 240, current flows from EL 230 to cathode 240, primarily by the conduction of electrons traveling from cathode 240 into EL 230. In a manner similar to that described with respect to Figure 1, HTL 220 injects holes into EL 230. The electrons and holes combine to form excitons in EL 230, which then decay preferentially by a photoemissive mechanism to emit light.

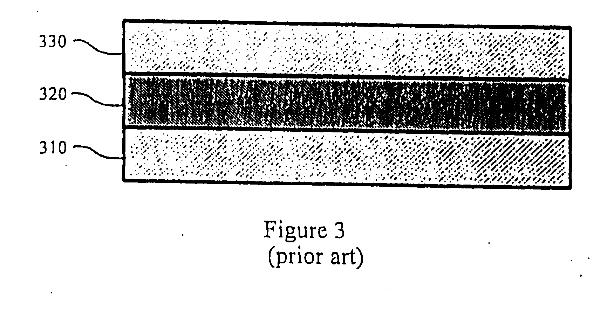

Figure 3 (prior art) shows a single layer OLED 300. An anode 310, an emissive layer (EL) 320, and a cathode 330 are stacked in that order. A single layer OLED functions in a manner similar to a double or single heterostructure OLED, except that the EL also functions as an HTL and an ETL. When a voltage is applied between anode 310 and cathode 330, current flows across EL 320, primarily by the conduction of electrons injected by cathode 330 and holes injected by anode 310. The electrons and holes combine to form excitons in EL 320, which then decay preferentially by a photoemissive mechanism to emit light.

Transparent OLEDs (TOLEDs) and stacked OLEDs (SOLEDs) are known to the art, as reported in U.S. Patent No. 5,703,436, Forrest et al., which is incorporated herein by reference. The TOLED had greater than 71% transparency when turned off and emitted light from both top and bottom device surfaces with high efficiency (approaching 1% quantum efficiency) when the device was turned on. Because they are transparent, TOLEDs can be stacked, and the light emitted by each TOLED in the stack can pass through the other TOLEDs. U.S. Patent No. 5,703,436, Forrest et al., discloses a SOLED having independently addressable stacked red, green, and blue OLEDs. Such a stack represents a significant step towards a high-resolution R-G-B pixel. An electrode having an Mg-Ag layer and an ITO layer was used between the OLEDs in the stack, where the Mg-Ag layer served as an electron injecting layer for one of the OLEDs contacting the electrode, and the ITO layer served as a hole injecting electrode for the other OLED. Each layer in the SOLED was independently addressable and emitted its own characteristic color, red, green, or blue. This colored emission could be transmitted through other OLEDs in the stack and the glass substrate, thus allowing the device to emit any color that could be produced by varying the relative output of the red, green, and blue color-emitting layers.

U.S. Patent No. 5,707,745, Forrest et al., which is incorporated herein by reference, disclosed an integrated SOLED having red, green and blue OLEDs in a stack, each independently controllable, such that the color and intensity of the SOLED can be independently varied. Such a SOLED provides a pixel suitable for use in a color display that has a compact pixel size relative to pixels that rely on three OLEDs side-by-side to achieve independently controllable red, green and blue emission. This compact pixel size enables high resolution, full color integrated pixels. Furthermore, relatively low cost fabrication techniques, as compared with prior art methods, may be utilized for making such devices.

However, high drive voltages and inefficient light emission have been observed when ITO electrodes are used in a SOLED, particularly in the upper OLEDs of the SOLED. See Z. Shen et al., *Three-Color, Tunable, Organic Light-*

*Emitting Devices*, Science, Vol. 276, page 2009 (June 27, 1997), which is incorporated by reference. High drive voltages and inefficient light emission increase the power requirements of the SOLED, and shorten the useful lifetime. There is therefore a need for a SOLED that has a lower drive voltage and more efficient light emission.

The electrodes (anodes and cathodes) of a SOLED are frequently made of indium tin oxide (ITO), as disclosed by U.S. Patent Nos. 5,707,745 and 5,703,436 to Forrest et al., which are incorporated by reference. ITO is a preferred electrode material because electrodes made of ITO may be made to transmit a large fraction of light in the visible spectrum, and to correspondingly absorb and/or reflect only a small fraction of light in the visible spectrum. As a result, a large fraction of the light emitted by an OLED having ITO electrodes reaches the viewer. Also, undesirable microcavity effects caused by reflective electrodes may be minimized by using ITO electrodes. Substrates pre-coated with ITO can be purchased, for example, from Donnelly Applied Films Corp., located in Boulder, Colorado. ITO can be deposited by a variety of methods, such as sputtering, thermal evaporation, chemical vapor deposition and spray pyrolysis. Moreover, ITO electrodes can be deposited on top of organic thin films without significantly damaging the thin film. For example, ITO can be deposited onto an organic thin film using a room temperature, low power, RF magnetron sputtering process, without significantly damaging to the organic thin film, as disclosed in U.S. Patent Application 08/928,800 (filed September 12, 1997), which is incorporated by reference. An ITO layer may also be incorporated into an electrode that comprises multiple layers, as disclosed in Burrows et al., *Color-tunable organic light emitting devices*, Appl. Phys. Lett. 69 (20), 2959 (1996). For example, an electrode may comprise a very thin (about 100Å) layer of metal(s) covered with a transparent conducting oxide thin film, such as ITO.

Wu et al., *Surface modification of indium tin oxide by plasma treatment: An effective method to improve the efficiency, brightness, and reliability of organic light emitting devices,* Appl. Phys. Lett. 70 (11), 1348 (1997), which is incorporated by reference, observes that the performance of OLEDs having ITO electrodes can be improved by exposing the ITO to oxygen plasma after the electrode is deposited, and before organic layers are deposited onto the electrode. However, exposure to oxygen plasma requires an extra process step, and gives only limited control over the amount and distribution of oxygen in the ITO.

## SUMMARY OF THE INVENTION

The present invention provides a method of fabricating an organic light emitting device. A layer of indium tin oxide is deposited. While the layer of indium tin oxide is being deposited, a controlled amount of additional oxygen is incorporated into a surface of the layer of indium tin oxide. An organic layer is then deposited onto the surface.

The present invention further provides an organic light emitting device having an anode, a cathode, and an organic layer. The anode has a surface into which additional oxygen was incorporated during fabrication. The organic layer is disposed between the anode and the cathode, and is in direct contact with the surface.

## BRIEF DESCRIPTION OF THE DRAWINGS

Figure 1 (prior art) shows a double heterostructure OLED.
Figure 2 (prior art) shows a single heterostructure OLED.
Figure 3 (prior art) shows a single layer OLED.
Figure 4 shows a SOLED embodiment of the present invention.
Figure 5 shows forward biased current density vs. voltage (*J-V*) characteristics of embodiments of the present invention.
Figure 6 shows luminescence vs. current density (*L-J*) characteristics of embodiments of the present invention.
Figure 7 shows emission spectra of embodiments of the present invention.
Figure 8 shows two-color tuning spectra of embodiments of the present invention.

## DETAILED DESCRIPTION

As discussed above, operational OLEDs and SOLEDs having ITO electrodes exist in the prior art. However, it is desirable to further reduce drive voltages and to improve the efficiency of these SOLEDs, particularly in the upper OLEDs of a SOLED.

The present invention achieves a low operating voltage, high quantum efficiency SOLED by incorporating additional oxygen during fabrication into a surface of an ITO anode that contacts an organic layer. As used herein, the "surface" of an electrode refers to a portion of the electrode, where the oxygen content of the portion has an effect on the injection of charge carriers into an adjacent organic layer. This "surface" may extend into the electrode. For example, the surface may extend to a depth of 60Å or more away from the adjacent organic layer. The term "additional oxygen" refers to an amount oxygen in excess of the amount in the bulk ITO, *i.e.*, ITO not at the "surface" of the electrode. The organic layer into which holes are injected from the anode may be a hole transporting layer of a single or double heterostructure OLED, an emissive layer of a single heterostructure or single layer OLED, or another type of organic layer, such as a hole injection enhancement layer. SOLEDs having anodes fabricated in accordance with the present invention exhibit performance superior to that of previously demonstrated SOLEDs.

While not intending to be limited as to any theory of how the present invention works, it is believed that the high drive voltages and inefficient light emission are caused in part by poor hole injection from the ITO anode into the organic layers. Furthermore, it is believed that incorporating additional oxygen into the surface of the ITO anode, the injection of holes into the organic layers is improved. The additional oxygen shifts the Fermi level of the ITO, resulting in better alignment between the Fermi level of the ITO and the Highest Occupied Molecular Orbital (HOMO) level of the organic material subsequently deposited onto the ITO, for many organic materials used to fabricate OLEDs. As a result, the energy barrier for holes jumping from the ITO into an adjacent organic layer is lowered, and hole injection from the ITO into the organic layer is improved. However, incorporating additional oxygen into ITO lowers the conductivity, due to a decrease in the concentration holes associated with oxygen vacancies, as disclosed by Fan et al., *X-ray photoemission spectroscopy studies of Sn- doped indium-oxide films*, J. App. Phys. 48 (8), 3524 (1977), which is incorporated by reference. A decrease in conductivity may increase drive voltage and decrease efficiency. However, the oxygen content throughout an ITO electrode affects conductivity, while the oxygen content at the surface affects hole injection properties. As a result, it is preferable to incorporate the oxygen into the surface of the electrode, which results in enhanced hole injection, but not into the rest of the electrode, to minimize any decrease in conductivity.

This theory explains observations of SOLEDs where the upper OLEDs, but not the lowest OLED, exhibit high operating voltages and low quantum efficiencies. These SOLEDs were fabricated on a commercially obtained substrate pre-coated with ITO. The anode of the lowest OLED was therefore exposed to air for an indeterminate amount of time before the SOLED was fabricated, allowing oxygen from the air to be incorporated into the electrode. On the other hand, the anodes of the upper OLEDs were deposited under the same vacuum used to deposit the adjacent organic layers, resulting in anodes having a lower oxygen content at the surface.

In a first embodiment of the invention, the oxygen content of an ITO anode is controlled using a modified sputtering process. During a portion of the sputtering process, oxygen gas is introduced into the sputtering gas at controlled times and in a controlled amount For example, a 600Å ITO electrode could be sputter deposited using an Ar flow of 150 sccm with no oxygen gas during the deposition of the first 540Å, with 0.1 sccm oxygen gas during the next 50Å, and with 0.2 sccm oxygen gas during the last 10Å. A surface of such an ITO anode, comprising the last 60Å deposited, incorporates oxygen in addition to that present in the rest of the ITO anode. The amount and distribution of oxygen in the ITO can be controlled with a great deal of precision, because the additional oxygen is incorporated into the surface of the ITO anode while the anode is being deposited. The organic layer into which holes are to be injected may then be deposited onto that surface of the anode, preferably without exposure to atmosphere. The depth of the ITO surface and the oxygen distribution within that surface may be varied from the specific examples disclosed. For example, such variations may depend upon the specific organic materials used and the various size parameters of the device.

In a second embodiment of the invention, the oxygen content of an ITO electrode is controlled by using oxygen-rich targets during a portion of the step of depositing a layer of indium tin oxide. The term "target" as used herein refers to a source of material used for depositing the ITO electrode. For example, an ITO electrode may be deposited from one or more targets of indium oxide ($In_2O_3$), tin oxide ($SnO$, $Sn_2O_3$, and/or $SnO_2$), ITO, and combinations thereof The oxygen content of a target may be controlled by selecting the oxidation state of the tin oxide in the target, as well as the concentration of oxygen vacancies in the oxides. Targets having a higher oxygen content are "oxygen-rich" relative to targets having a lower oxygen content. By changing one or more targets during the deposition of the ITO electrode, or by changing the rates at which material is co-deposited from multiple targets, the oxygen content of the electrode may be controlled. For example, the ITO electrode may be deposited by co-deposition from an oxygen-rich target and an oxygen-poor target, where the percentage of the co-deposition from the oxygen-rich target is increased during a portion of the deposition. The amount and distribution of oxygen in the ITO can be controlled with a great deal of precision, because the additional oxygen is incorporated into the surface of the ITO anode while the anode is being deposited. The organic layer into which holes are to be injected may then be deposited, preferably without exposure to atmosphere.

The present invention may also be used in conjunction with other methods of depositing ITO, such as chemical vapor deposition and spray pyrolysis, for example.

The present invention allows additional oxygen to be incorporated into the ITO anodes of an OLED in a controlled manner. The amount and distribution of oxygen in the ITO anode can be controlled. Advantageously, the present invention does not require prolonged exposure to air, which may be impractical in a commercial manufacturing environment where long process steps add to the cost of device fabrication. Incorporating additional oxygen into an ITO electrode during fabrication is superior to exposing the ITO to oxygen plasma after fabrication, because incorporation during fabrication allows the amount and distribution of oxygen to be controlled with more precision. Also, incorporating additional oxygen during the fabrication of an ITO electrode involves modifying manufacturing step already present, as opposed to adding an additional step, such as exposure to oxygen plasma or air. Avoiding such an additional step may facilitate manufacture and decrease cost. Moreover, an additional step such as exposure to oxygen plasma may damage any organic layers underlying the ITO electrode, while incorporating additional oxygen during an existing manufacturing step is unlikely to cause such damage. The present invention is particularly well adapted to the fabrication of SOLEDs, where layers of ITO and layers of organic materials are deposited in alternating fashion, often in rapid succession, because additional oxygen can be quickly incorporated into the ITO without extra process steps and without exposing the SOLED to atmosphere.

OLEDs fabricated in accordance with the present invention may be used in a wide variety of consumer products, including computers, televisions, telecommunications products with a display component, vehicles, billboards, signs, large area wall, theatre, stadium screens, xerography, heads-up displays for windshields and helmet visors, and video games.

The present invention will now be described in detail with respect to showing how certain specific representative embodiments thereof can be made, the materials, apparatus and process steps being understood as examples that are intended to be illustrative only. In particular, the invention is not intended to be limited to the methods, materials, conditions, process parameters, apparatus and the like specifically recited herein.

## **EXAMPLES**

Example 1:

Four substrates coated with ITO were prepared as follows:

Sample A

An ITO thin film was deposited to a total thickness of 600Å onto a pre-cleaned glass substrate. The deposition was by sputtering, using an RF magnetron sputter system. Access to the sputtering chamber was provided by a load-lock. The load lock was evacuated with a turbo pump, and the sputtering chamber was pumped to a base pressure of $5 \times 10^{-8}$ Torr prior to sputtering. A magnetron sputtering gun, manufactured by AJA International, was powered by an RF power supply manufactured by Advanced Energy in conjunction with an auto-tunable impedance matching network. The sputtering target was a 2-inch diameter plate of a hot-pressed sintered mixture of 10% by weight $SnO_2$ and 90 % by weight $In_2O_3$, 99.99% pure. The sputter gas was 6-9's pure (99.9999%) Ar, introduced into the sputtering chamber at a flow rate of 150 sccm via a mass flow controller. The pressure inside the sputtering chamber was controlled dining deposition by a throttle valve along with the cryo pump. The plasma was started at a pressure of 20 mTorr, and the growth pressure was 5 m Torr. The substrates were positioned about 15 cm above the target, which was shuttered, and were held in place by a water-cooled non-rotating substrate holder.

For deposition of the last 60 Å of ITO, 4-9's pure (99.99%) $O_2$ was added to the sputter gas, first at a flow rate of 0.1 sccm, and then at 0.2 sccm during the final 10 Å. The amount of $O_2$ was controlled by a mass flow controller.

After the ITO was deposited, Sample A was stored in dry nitrogen for 10 hours before an OLED was fabricated, and was exposed to atmosphere only very briefly during transfer to and from the dry nitrogen environment.

Sample B

An ITO thin film was deposited to a thickness of 600Å onto a pre-cleaned glass substrate, using the procedure of Example 1. However, oxygen was not added to the sputter gas.

After the ITO was deposited, Sample B was stored in dry nitrogen for 10 hours before an OLED was fabricated, and was exposed to atmosphere only very briefly during transfer to and from the dry nitrogen environment.

Sample C

An ITO thin film was deposited to a thickness of 600Å onto a pre-cleaned glass substrate, using the procedure of Example 1. However, oxygen was not added to the sputter gas.. After the ITO was deposited, Sample C was exposed to air for 10 hours before an OLED was fabricated.

Sample D

A substrate pre-coated with an ITO thin film was commercially obtained from Donnelly Applied Films Corp., located in Boulder, Colorado. The ITO thin film had a nominal thickness of 1600Å.

The ITO on Sample D was exposed to air for an indeterminate amount of time before an OLED was fabricated.

A single heterostructure OLED was then simultaneously grown on top of each of Samples A, B, C and D, according to the following procedure:

(1) A 100 Å thick hole injecting layer of copper phthalocynine (CuPc) was deposited by thermal evaporation in a vacuum of $< 10^{-6}$ Torr.

(2) A 400 Å thick hole transporting layer of 4,4'-bis [N-(1-napthyl)-N-phenyl-amino]biphenyl ($\alpha$-NPD) was deposited by thermal evaporation in a vacuum of $< 10^{-6}$ Torr.

(3) A 500 Å thick electron transporting and light emitting layer of tris-(8-hydroxyquinoline) aluminum ($Alq_3$) was deposited by thermal evaporation in a vacuum of $< 10^{-6}$ Torr.

(4) A 2000 Å thick metal cathode of Mg and Ag was deposited by co-evaporation of Mg and Ag (9:1 by mass).

(5) A 500 Å thick Ag cap was deposited by thermal evaporation.

Each of the samples was then tested to determine the drive voltage required to achieve a current density of J =10mA/cm$^2$. A lower drive voltage means that the device is more efficient and is expected to have a longer lifetime. High drive voltages are caused by factors such as low conductivity and poor carrier injection from one layer to the next. The results are listed in Table 1, along with the growth conditions, thicknesses, and sheet resistances of the ITO films of each Sample.

Table 1

| Drive voltages of OLEDs using ITO anodes grown at different conditions. | | | | |
|---|---|---|---|---|
| **Sample** | **Growth condition** | **Thickness** | **Sheet resistance** | **Drive voltage at J = 10mA/cm$^2$** |
| A | Use O$_2$ near end of deposition. | 600Å | 300Ω/square | 9V |
| B | No O$_2$ as grown | 600Å | 300Ω/square | 12V |
| C | No O$_2$, air exposure after growth | 600Å | 300Ω/square | 10V |
| D | Commercially obtained | 1600Å | 20Ω/square | 9V |
| **Sample** | **Growth condition** | **Thickness** | **Sheet resistance** | **Drive voltage at J = 10mA/cm$^2$** |

Table 1 shows that the ITO electrode having additional oxygen incorporated during deposition (Sample A) performs better than the ITO electrode deposited without additional oxygen (Sample B), and had a performance comparable to the commercially obtained ITO film (Sample D). Table 1 also shows that exposing the electrode deposited without additional oxygen (Sample B) to air for 10 hours (Sample C) improves the performance of the electrode, but not as much as incorporating additional oxygen during the sputter process (Sample A). Incorporating additional oxygen into the ITO, either during deposition or by exposure to oxygen after deposition, results in an improved electrode that leads to a device having a lower drive voltage (Samples A, C and D v. Sample B). However, incorporating additional oxygen into the electrode during deposition results in a superior drive voltage as compared to a similar electrode exposed to air, and requires less time (Sample A v. Sample C).

Example 2

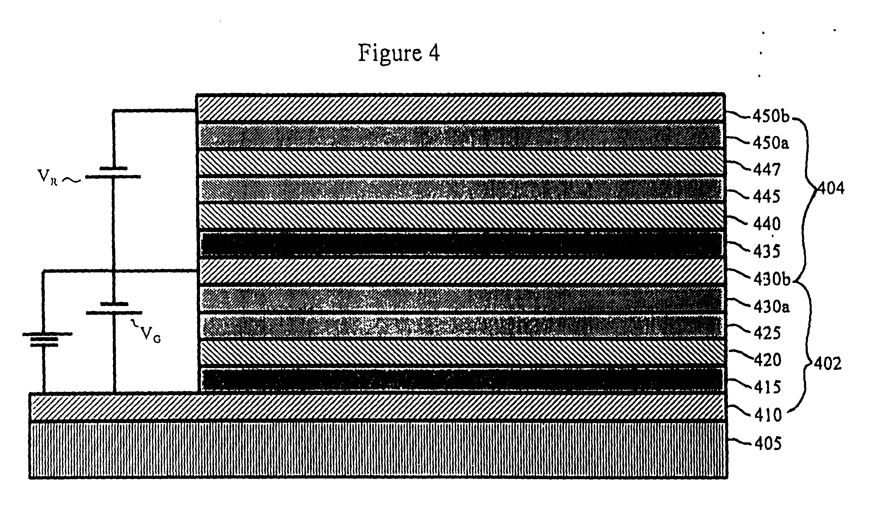

A two-color stacked OLED 400 was fabricated, having an improved ITO electrode similar to that of Sample A from Example 1. The top OLED 404 having two semitransparent electrodes and exhibits a reduced operating voltage and high efficiency for the top element along with negligible color distortion and viewing angle dependence of the emission spectrum. Figure 4 shows the stacked OLED 400 of Example 2. A top OLED 404 is stacked on top of a bottom OLED 402. OLEDs 402 and 404 were both transparent OLEDs (TOLEDs). The SOLED of Example 2 was fabricated as follows:

(1) A glass layer 405 pre-coated with an ITO layer 410 was obtained from Donnelly Applied Films Corp. ITO layer 410 had a nominal thickness of 1600Å and a sheet resistance of 20 Ω/square, and serves as an anode for bottom OLED 402. ITO layer 410 was cleaned and photolithographically patterned to form the anode for bottom OLED 402. The ITO layer 410 was treated for 2 minutes in a 31 W RF oxygen plasma.

(2) A hole injection enhancement layer 415, a hole transport layer 420, and an emissive layer 425 were sequentially deposited by thermal evaporation in a vacuum of < $10^{-6}$ Torr. Hole injection enhancement layer 415 was a 110Å thick layer of CuPc, hole transport layer 420 was a 400Å thick layer of α-NPD, and emissive layer 425 was a 500Å thick layer of Alq$_3$, adapted to emit green light.

(3) An electrode 430 was then deposited, having a layer 430a and a layer 430b. Layer 430a was a 200 Å thick layer of Mg:Ag (9:1 by mass), and layer 430b was a 600Å thick layer of ITO, deposited according to the process of Example 1, Sample A. Layer 430a serves as the cathode of bottom OLED 402, and layer 430b serves as the anode of top OLED 404.

(4) A hole injection enhancement layer 435, a hole transport layer 440, an emissive layer 445, and an electron transport layer 447 were sequentially deposited by thermal evaporation in a vacuum of < $10^{-6}$ Torr. Hole injection enhancement layer 435 was a 110Å thick layer of CuPc, hole transport layer 440 was a 400Å thick layer of α-NPD, emissive layer 445 was a 400Å thick layer of Alq$_3$, and electron transport layer 447 was a 150Å thick layer of Alq$_3$. Emissive layer 445, which also serves as an electron transport layer, was adapted to emit red light by doping with a 9% concentration of phosphor,2,3,7,8,12,13,17,18-octaethyl-21H,23H-phorsphine platinum (PtOEP).

(5) An electrode 450 was then deposited, having a layer 450a and a layer 450b. Layer 450a was a 200 Å thick layer of Mg:Ag (9:1 by mass), and layer 450b was a 600Å thick layer of ITO. Layer 450a serves as the cathode of top OLED 404. Layer 450b serves as a protective cap for electrode 450, and also contributes to the conductivity of electrode 450.

A discrete green-emitting OLED similar to bottom OLED 402 was fabricated at the same time as bottom OLED 402, according to steps 1-3. Similarly, a discrete red-emitting OLED similar to top OLED 404 was fabricated at the same time as top OLED 404, according to steps 1, 4 and 5. However, the anode of this discrete red-emitting OLED was similar to ITO layer 410, not layer 430b.

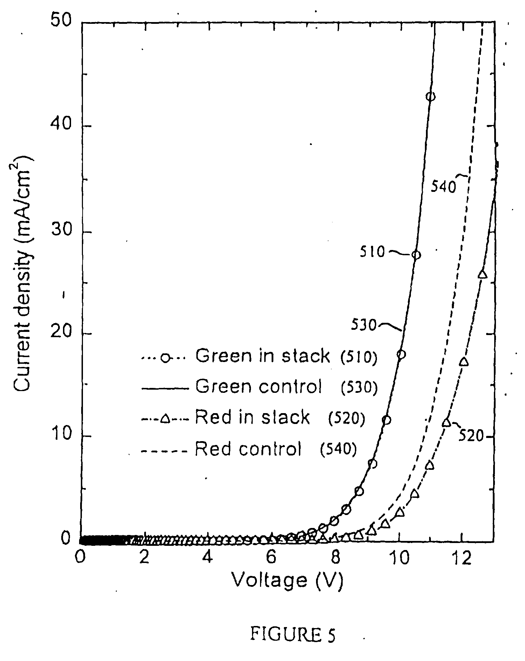

Figure 5 shows forward biased current density vs. voltage (*J-V*) characteristics. Plots 510, 520, 530 and 540 show the characteristics of bottom OLED 402 (green in stack), top OLED 404 (red in stack), the discrete green-emitting OLED (green control), and the discrete red-emitting OLED (red control), respectively. Top OLED 404 exhibits a drive voltage of about 12 V. This drive voltage is significantly lower than the drive voltages between 15 V and 25 V reported for similar OLEDs by Burrows et al., *Color-tunable organic light emitting devices*, Appl. Phys. Lett. 69 (20), 2959 (1996), which is incorporated by reference. The drive voltage for top OLED 404 is only 1 V higher than that of the discrete red-emitting OLED.

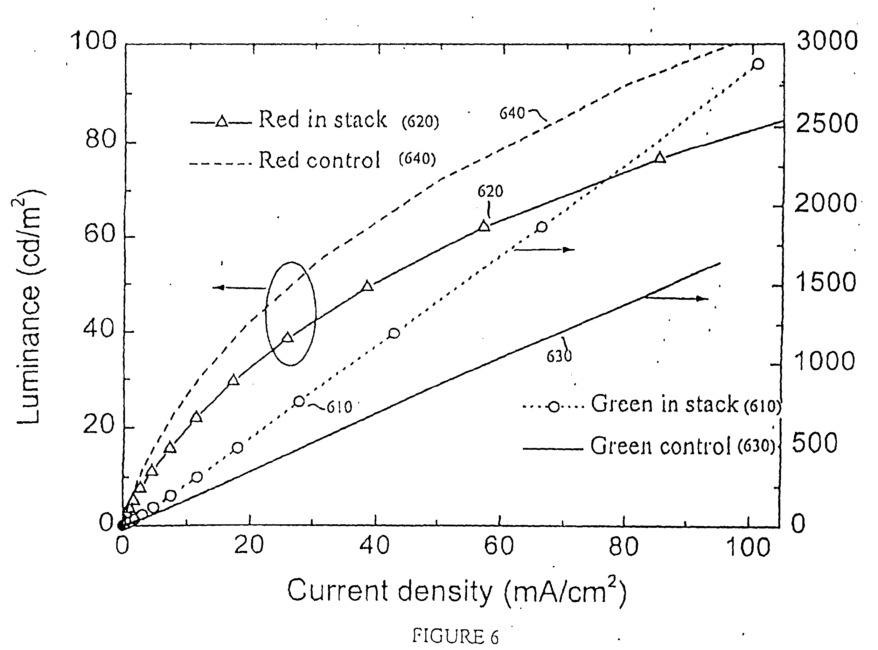

Figure 6 shows luminescence vs. current density (*L-J*) characteristics. Plots 610, 620, 630 and 640 show the characteristics for bottom OLED 402 (green in stack), top OLED 404 (red in stack), the discrete green-emitting OLED (green control), and the discrete red-emitting OLED (red control), respectively. The luminance is based on a measurement of the light emitted from the bottom of glass layer 405, *i.e.*, the side opposite the OLEDs. The quantum efficiencies calculated from these measurements are 1% for bottom OLED 402, 0.4% for top OLED 404, in comparison with 0.8% for the discrete green-emitting OLED, and 0.7% for the discrete red-emitting OLED. The ratio of luminescence emitted from the top of SOLED 400 to luminescence emitted from the bottom of SOLED 400 was measured as 1:0.067 for OLED 404 and 1:0.51 for OLED 402. Hence, the total external quantum efficiency of top OLED 404 is 1.1%, and that of bottom OLED 402 is 0.6%.

The red OLEDs, *i.e.*, top OLED 404 and the discrete red-emitting OLED, exhibit a decrease in efficiency at high current densities relative to the green OLEDs, *i.e.*, bottom OLED 402 and the discrete green-emitting OLED, as shown in Figure 6 by a lower slope in the plots of luminescence v. current density for the red OLEDs at higher current densities. This decrease in efficiency is likely due to slow (~30 μs) phosphorescent decay, leading to saturation of the PtOEP sites in the emissive region. Top OLED 404 exhibits a luminance of 35 cd/m$^2$, and a current density of 24 mA/cm$^2$ at a drive voltage of 12 V. These numbers are sufficient to meet video display standards.

If an OLED or SOLED has significant internal reflections, a microcavity effect may cause the wavelength of light emitted to vary depending on the viewing angle. Emission spectra were measured for OLED 402, OLED 404, the discrete red-emitting OLED, and the discrete green-emitting OLED.

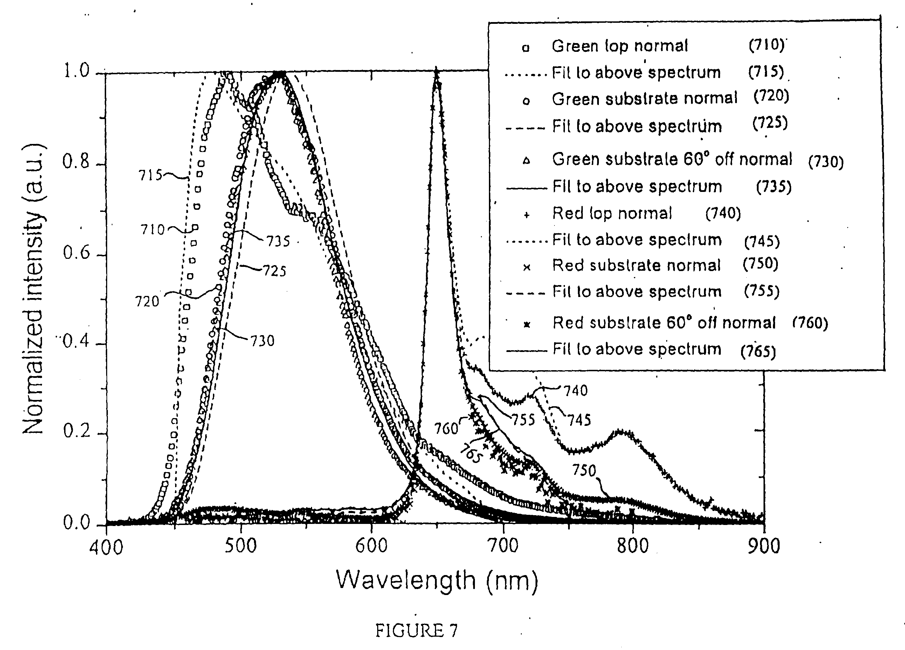

Figure 7 shows emission spectra of light emitted from OLED 402 and OLED 404. Plot 710 (green top normal) is a plot of a spectrum emitted from OLED 402 through the top of SOLED 400 in a direction normal to the plane of SOLED 400. Plots 720 (green substrate normal) and 730 (green substrate 60° off normal) are plots of spectra emitted from OLED 402 trough the bottom of SOLED 400, in directions normal to the plane of SOLED 400 and 60° off-normal, respectively. Plot 740 (red top normal) is a plot of a spectrum emitted from OLED 404 trough the top of SOLED 400 in a direction normal to the plane of SOLED 400. Plots 750 (red substrate normal) and 760 (red substrate 60° off normal) are plots of spectra emitted from OLED 404 through the bottom of SOLED 400, in directions normal to the plane of SOLED 400 and 60° off-normal, respectively.

Plots 720 and 730 are very similar, as are plots 750 and 760, demonstrating that the angular dependencies of the bottom emission spectra are negligible for both OLED 402 and OLED 404. As a result, SOLEDs similar to SOLED 400 are suitable for applications such as large screen televisions, where the perceived color preferable remains relatively constant as the viewing angle is changed. Plot 740 is very similar to plot 750, indicating that top and bottom emission of OLED 404 are about the same. However, plot 710 is shifted about 50 nm. relative to plot 720, indicating that there are some microcavity effects present in SOLED 400.

Measurements (not shown) corresponding to the measurements shown in Figure 7 were taken for the discrete red-emitting and green-emitting OLEDs. The measured emission spectra of each discrete OLED remained relatively constant, regardless of whether the spectra were measured from the top or bottom of the device, and regardless of viewing angle. This lack of change in the emission spectra indicate that any microcavity effects in the discrete OLEDs are weak.

Curves 715, 725, 735, 745, 755 and 765 are fits to plots 710, 720, 730, 740, 750 and 760, respectively, according to a model of cavity effects disclosed by U.S. Patent Application 08/858,994, filed May 20, 1997, which is incorporated herein by reference. This fitting model uses several parameters, including the refractive indices of the organic and electrode layers of SOLED 400, *i.e.*, layers 410, 415, 420, 425, 430, 435, 440, 445 and 450. Hole injection enhancement layers 415 and 435 were disregarded for purposes of the fitting. Table 2 shows dispersion parameters for the materials used in the fitting. The dispersion parameters for $Alq_3$ were taken from the literature, and the other values in Table 2 were measured. The refractive index $n(\lambda)$ of a particular material for a particular wavelength of light was calculated as $n(\lambda)=n(\lambda_0) + a(\lambda_0 - \lambda)^2$, using the values of $n(\lambda_0)$, $\lambda_0$ and $a$ listed in Table 2.

The thicknesses of the organic layers were calibrated to an accuracy of 2% during fabrication, and were treated as well defined parameters during the fitting. The exciton distributions in the emissive regions were assumed to decay exponentially with distance from the $\alpha$-NPD/luminescent layer interface with a characteristic diffusion length of 100Å. The actual thickness of electrode layers 430a 430b, 450a and 450b are somewhat uncertain, because Mg:Ag layers, such as layers 430a and 450a may be oxidized to some extent by the subsequent deposition of an ITO layer, such as layers 430b and 450b. This oxidation can change the thickness as well as the optical properties of layers 430a, 430b, 450a and 450b. The thickness of these were therefore selected to obtain a good fit. Curves 715, 725, 735, 745, 755, and 765 were obtained by assuming a thickness of 200Å for Mg:Ag layers 430a and 450a and a thickness of 780Å for ITO layers 430b and 450b. The discrepancy between the red emission spectra and corresponding fits in the IR spectral region is attributed to the dispersion in hole injection enhancement layer 415, which was not included in the calculation.

Table 2

| Dispersion parameters of materials used in modeling the SOLED emission spectra. | | | |
|---|---|---|---|
| **Material** | $\lambda_0(\mu m)$ | $n(\lambda_0)$ | $\alpha(\mu m^{-2})$ |
| $Alq_3$ | 0.60 | 1.72 | 1.8 |
| $\alpha$-NPD | 0.60 | 1.78 | 4.5 |
| As-sputtered ITO | 0.83 | 1.95 | 1.5 |
| Pre-coated ITO | 0.60 | 1.80 | 9.0 |

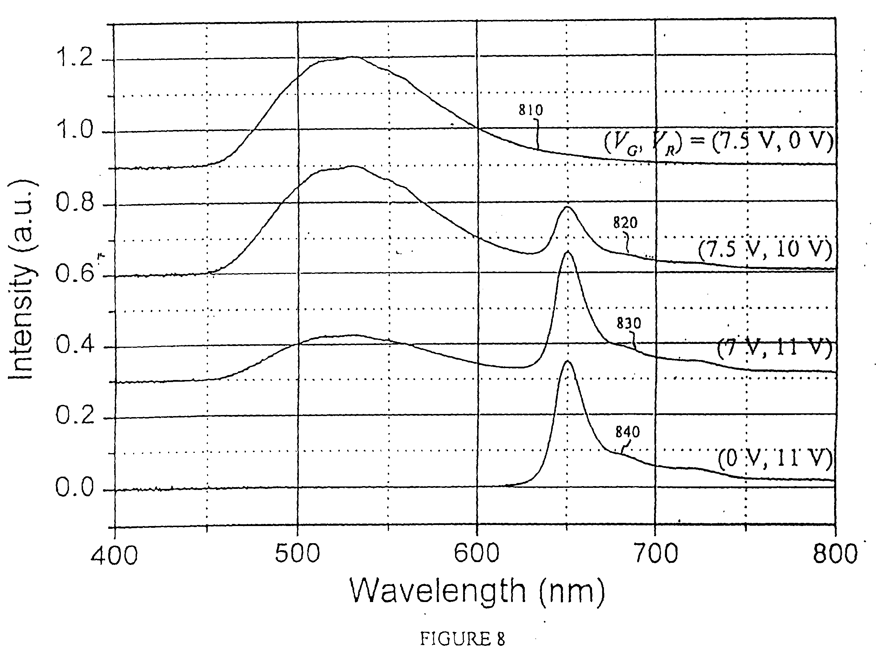

Figure 8 shows two-color tuning spectra, obtained by measuring the emission from the bottom of SOLED 400 in a direction normal to the plane of SOLED 400 while applying different combinations of voltages $V_G$ across OLED 402 and $V_R$ across OLED 404. Plot 810 shows the spectra for $(V_G,V_R) = (7.5V, 0V)$. Plot 820 shows the spectra for $(V_G,V_R,) = (7.5V, 10V)$. Plot 830 shows the spectra for $(V_G,V_R) = (7V, 11V)$. Plot 840 shows the spectra for $(V_G,V_R) = (0V, 11V)$. Based on the plots of Figure 8, Commission Internationale de L'Éclairage (CIE) chromaticity coordinates of (0.30, 0.56) and (0.71, 0.29) were calculated for the emissions of OLEDs 402 and 404, respectively. CIE chromacity coordinates of (0.29, 0.56) for the discrete green-emitting OLED and (0.71, 0.29) for the discrete red emitting OLED were calculated based on similar measurements taken of those OLEDs. These results show that the chromacity coordinates of the emissions of bottom OLED 402 and top OLED 404 are nearly identical to those of the discrete green and red-emitting OLEDs, respectively.

Similar calculations were performed based on two-color tuning spectra measured from the bottom of SOLED 400 in a direction 60° off-normal to the plane of SOLED 400. CIE chromacity coordinates of (0.29, 0.56) and (0.72, 0.28) were calculated for the emissions of OLEDs 402 and 404, respectively, demonstrating that the dependence of the colors emitted on the viewing angle is negligible.

It is expected that SOLED 400 can be further improved by reducing the thickness of Mg:Ag layers 430a and 450a. Such a reduction in thickness is expected to reduce internal reflections, microcavity effects, and the dependence of perceived color on viewing angle, while increasing transparency.

Over 10 SOLEDs 400 were fabricated, and the yield was 100%. This high yield in devices that have been subjected to ITO sputtering twice indicates the suitability of sputtered ITO electrodes for use in high contrast, high-resolution multi-color displays. It is also expected that semitransparent SOLEDs incorporating such electrodes, such as SOLED 400, are suitable for use as pixels in such displays.

Those with skill in the art may recognize various modifications to the embodiments of the invention described and illustrated herein. Such modifications are meant to be covered by the spirit and scope of the appended claims.

## Claims

1. A method of fabricating an organic light emitting device, comprising the steps of:

   a. depositing a layer of indium tin oxide;

   b. incorporating a controlled amount of additional oxygen into a surface of the layer of indium tin oxide during the step of depositing a layer of indium tin oxide;

   c. depositing an organic layer onto the surface,

   wherein the additional oxygen is incorporated by using an oxygen-rich target during a portion of the step of depositing a layer of indium tin oxide.

2. The method comprising steps a., b. and c. of claim 1, wherein the additional oxygen is incorporated by co-depositing an oxygen-rich compound during a portion of the step of depositing a layer of indium tin oxide.

3. The method comprising steps a., b. and c. of claim 1, wherein the layer of indium tin oxide is deposited by chemical vapor deposition.

4. The method comprising steps a., b. and c. of claim 1, wherein the layer of indium tin oxide is deposited by spray pyrolysis.

5. The method comprising steps a., b. and c. of claim 1, and further comprising the steps of depositing a hole injection enhancement layer after the step of incorporating a controlled amount of additional oxygen into a surface of the layer of indium tin oxide and before the step of depositing an organic layer.

6. An organic light emitting device, comprising

   a. an anode made of indium tin oxide and having a surface into which a controlled amount of additional oxygen is incorporated during the fabrication of the anode;

   b. a cathode; and

   c. an organic layer disposed between the anode and the cathode, and in direct contact with the surface of the anode,

   wherein the additional oxygen is incorporated by using an oxygen-rich target during a portion of the step of depositing a layer of indium tin oxide.

7. A device comprising the features a., b. and c. of claim 6, wherein the additional oxygen is incorporated by codepositing an oxygen-rich compound during a portion of the step of depositing a layer of indium tin oxide.

8. A device comprising the features a., b. and c. of claim 6, wherein the layer of indium tin oxide is deposited by chemical vapor deposition.

9. A device comprising the features a., b. and c. of claim 6, wherein the layer of indium tin oxide is deposited by spray pyrolysis.

**10.** A device comprising the features a., b. and c. of claim 6, and further comprising the step of depositing a hole injection enhancement layer after the step of incorporating a controlled amount of additional oxygen into a surface of the layer of indium tin oxide and before the step of depositing an organic layer.

**11.** A consumer product including the device according to any of claims 6 to 10.

Figure 1
(prior art)

Figure 2
(prior art)

Figure 3
(prior art)

330

320

310

Figure 4

FIGURE 5

FIGURE 6

FIGURE 7

EP 0 987 774 A2

FIGURE 8